# EUROPÄISCHE PATENTSCHRIFT

(11) **EP 0 602 197 B1**
(45) Veröffentlichungstag und Bekanntmachung des Hinweises auf die Patenterteilung: **28.04.1999**
(21) Anmeldenummer: 93909782.0
(22) Anmeldetag: 21.05.1993
(51) Int. Cl.: H01L 27/02, G05F 3/20

(54) **INTEGRIERTER CMOS-HALBLEITERSCHALTKREIS**
INTEGRATED CMOS SEMICONDUCTOR CIRCUIT
CIRCUIT INTEGRE CMOS A SEMI-CONDUCTEURS

(30) Priorität: 01.07.1992 DE 4221575
(43) Veröffentlichungstag der Anmeldung: 22.06.1994
(73) Patentinhaber: International Business Machines Corporation, Armonk, N.Y. 10504 (US)
(72) Erfinder: KÖTZLE, Gunther, D-7270 Nagold-Vollmaringen (DE); KREUTER, Volker, D-7036 Schönaich (DE); LUDWIG, Thomas, D-7032 Sindelfingen (DE); SCHETTLER, Helmut, D-7405 Dettenhausen (DE)
(74) Vertreter: Schäfer, Wolfgang, Dipl.-Ing.
(86) Internationale Anmeldenummer: DE9300443
(87) Internationale Veröffentlichungsnummer: WO9401890

(56) Entgegenhaltungen:
- PATENT ABSTRACTS OF JAPAN vol. 014, no. 005 (E-869)9. Januar 1989 & JP,A,1 253 264 ( SHARP CORP ) 9 October 1989
- PATENT ABSTRACTS OF JAPAN vol. 015, no. 254 (E-1083)27. Juni 1991 & JP,A,3 082 151 ( NEC CORP ) 8 April 1991
- ELECTRONICS LETTERS Bd. 26, Nr. 17, 16. August 1990, STEVENAGE GB Seiten 1381 - 1382 , XP000108969 U. GATTI ET AL. 'Automatic switching of substrate bias or well bias in CMOS-IC'
- PATENT ABSTRACTS OF JAPAN vol. 013, no. 240 (E-767)6. Juni 1989 & JP,A,1 042 850 ( NEC CORP ) 15 February 1989

## Beschreibung

Die Erfindung betrifft einen integrierten Halbleiterschaltkreis in CMOS-Technik und ein Datenverarbeitungssystem, die sich durch geringen Energieverbrauch auszeichnen.

Die bisher bekannten und in der nahen Zukunft zu erwartenden Computer, insbesondere die tragbaren Personalcomputer, leiden daran, daß der Betrieb zu viel Energie benötigt, was sich bei Batteriebetrieb besonders nachteilig bemerkbar macht. Die großen Energieverbraucher sind der Bildschirm, die Festplatte, der interne Speicher, der Prozessor und eventuell angeschlossene zusätzliche periphere Geräte. Bisher bekannte Maßnahmen zur Verlängerung des netzunabhängigen Arbeitens bei den tragbaren PCs ist der "Standby Modus", bei dem die Hintergrundbeleuchtung des Bildschirms bei Nichtbenutzung abgeschalten und auf Tastendruck zugeschaltet und die Festplatte angehalten wird. Eine weitere Maßnahme ist ein intelligentes Powermanagement, das dafür sorgt, daß die Komponenten, die gerade nicht gebraucht werden, abgeschaltet werden und damit keinen Strom verbrauchen. Stromeinsparung kann beispielsweise auch durch Reduzierung der Taktfrequenz erreicht werden, wenn eine geringere Arbeitsleistung ausreichend ist. Eine andere bekannte Maßnahme ist die Abschaltung der Spannung, wobei die wichtigen Informationen für den Neustart in einem speziellen Teil des Prozessors gespeichert werden ("Rest" oder "Sleep Modus"). Eine noch andere zukünftige Art ist der Einsatz von Prozessoren, die mit einer Versorgungsspannung von 3,3 Volt statt wie bisher 5 Volt arbeiten.

Aus dem IBM Technical Disclosure Bulletin, Vol. 20, No. llA, April 1978, Seite 4415, wird zur Minimierung des Spannungsverbrauchs bei peripheren Hilfsschaltkreisen von Speichern, die Substratvorspannung erhöht. Bei gleicher Versorgungsspannung wird die Substratvorspannung soweit erhöht, daß die Hilfsschaltkreise mit der minimalen Arbeitsfrequenz arbeiten. Dadurch wird der Ladestrom bei gleicher Drain-Source-Spannung der Feldeffekttransistoren (FET) reduziert, was zu einem geringeren Energieverbrauch führt.

Alle diese Maßnahmen haben bisher noch nicht ausgereicht, um einen ausreichend langen netzunabhängigen Betrieb von tragbaren PCs zu erlauben.

Der vorliegenden Erfindung liegt das Problem zugrunde, einen integrierten Halbleiterschaltkreis und ein Datenverarbeitungssystem zu schaffen, das zusätzlich zu den bereits bekannten Maßnahmen eine weitere Energieeinsparung und damit einen noch längeren netzunabhängigen Betrieb ermöglicht.

Dieses Problem wird durch die vorliegende Erfindung, wie sie in Anspruch 1 beschrieben ist, gelöst.

Zweckmäßigerweise werden, um den optimalen Effekt zu erzielen, möglichst viele CMOS-Transistorpaare auf einem Halbleiterchip derart ausgebildet sein, daß sie stabil betreibbar sind, d.h. bei bestimmten vorgegebenen Versorgungsspannungen arbeiten die Transistoren zwar mit verschiedenen Geschwindigkeiten, jedoch im Bereich der durch die Schaltungsanordnung vorgegeben Arbeitspunkte. Dies wird erreicht, indem jede Versorgungsspannung, die für den Betrieb der Transistoren ausgewählt wird, eine zugeordnete Schwellwertspannung aufweist, die über die Wannenvorspannung und die Substratvorspannung einstellbar ist. Normalerweise werden zwei Versorgungsspannungen ausgewählt, die sich deutlich hinsichtlich des Energieverbrauchs für die Schaltungen und der Taktfrequenz unterscheiden, und zwischen denen hin und her geschaltet wird. Es ist aber auch denkbar, Spannungswerte dazwischen noch zusätzlich auszuwählen.

Durch die Einstellung einer zugeordneten Schwellwertspannung wird der beschriebene stabile Betrieb erreicht, und zwar indem bei höherer Versorgungsspannung eine betragsmäßig höhere und bei niedrigerer Versorgungsspannung eine betragsmäßig niedrigere Schwellwertspannung eingestellt wird.

Die Einstellung erfolgt mittels einer Substratvorspannungsgeneratorschaltung, die mit dem Substrat und einer Wannenvorspannungsgeneratorschaltung, die mit der Wanne jedes Transistorpaares verbunden ist. Diese Generatorschaltungen stellen in Abhängigkeit eines Eingangssignals, das der Höhe der Versorgungsspannung repräsentiert, die jeweilige, die Höhe der Versorgungsspannung entsprechende Vorspannung ein, um die Schwellwertspannung entsprechend anzupassen. Das Eingangssignal kann dabei vorzugsweise mittels eines Spannungsdetektors erzeugt werden. Damit wird erreicht, daß sobald sich die Versorgungsspannung ändert schnellstens der neue Arbeitspunkt bei entsprechender Schwellwertspannung eingestellt wird. Dies kann einerseits durch Umschalten von Versorgungsspannung auf Batteriespannung oder auf eine interne Spannung, weil aufgrund des augenblicklichen Betriebs keine höhere Spannung erforderlich ist, erfolgen.

Vorteilhafterweise sollten die Versorgungsspannungen ungefähr 3,6 V für hohe Leistung und 1,2 V für geringe Leistung betragen, wenigstens wenn es sich um integrierte Halbleiterschaltkreise für tragbare PCs handelt. Die vorliegende Erfindung ist jedoch grundsätzlich anwendbar, wenn es sich um die Reduzierung einer Versorgungsspannung auf eine andere Versorgungsspannung handelt. Bei der Reduzierung der Versorgungsspannung kann es sich dabei um den Faktor 2 oder mehr handeln, je nachdem wie hoch der Ausgangsversorgungsspannungswert ist. Die Dotierung des Substrats sollte vorteilhafterweise unterhalb der Oberfläche eine Konzentration von 7,5x10¹⁵ bis 4x10¹⁶ cm⁻³, vorzugsweise 2,5x10¹⁶ cm⁻³ aufweisen, damit die Transistoren bei jeder der gewünschten Versorgungsspannung im Bereich um 3,6 V und 1,2 V und den entsprechenden Schwellwertspannung stabil arbeiten können.

Das erfindungsgemäße Datenverarbeitungssystem, wie Personalcomputer (PC) und insbesondere tragbarer PC, weist wenigstens einen integrierten Halbleiterschaltkreis mit den vorstehend beschriebenen Eigenschaften auf, so daß damit zusätzlich zu den bereits im Stand der Technik bekannten Maßnahmen Energie gespart werden kann, was sich bei den tragbaren PCs in einer wesentlich längeren Netzunabhängigkeit auszahlt, aber auch bei Netzbetrieb von Vorteil für den Betreiber und die Umwelt ist, da das Datenverarbeitungssystem nur dann mit hoher Spannung arbeitet, wenn es aufgrund der augenblicklich durchzuführenden Operationen erforderlich ist. Die Erzeugung des Eingangssignals kann auf dem integrierten Halbleiterschaltkreis oder auch durch andere Elemente des Datenverarbeitungssystems erfolgen. So kann beispielsweise ein Spannungsdetektor auf dem integrierten Halbleiterschaltkreis direkt oder in einer anderen Systemeinheit vorgesehen sein. Vorteilhafterweise kann auch die Auswahl der Versorgungsspannung und damit das Eingangssignal für die Vorspannung in Abhängigkeit von der Auslastung des integrierten Halbleiterschaltkreises geschehen, wobei automatisch (programmgesteuert) nur dann die höhere Versorgungsspannung gewählt wird, wenn die Operationen des integrierten Halbleiterschaltkreises dies gerade erfordern. Auch kann die Steuerung in Abhängigkeit von der Dauer der Nichtbenutzung der zugehörenden Eingabeeinheit erfolgen, was in Kombination mit der Steuerung in Abhängigkeit von der Auslastung des integrierten Halbleiterschaltkreises noch mehr Energieersparnisse bringt.

Durch den erfindungsgemäßen integrierten Halbleiterschaltkreis wird durch Vorsehen einer eigenen Spannungsversorgung für die Einstellung der Schwellwertspannung zusätzlich zu der Schaltkreisversorgungsspannung eine einfache Möglichkeit geschaffen, ein Datenverarbeitungssystem zu erstellen, das mit einer sehr geringen Spannung für die meistens Anwendungsfälle voll funktionsfähig ist, ohne daß der Benutzer bemerkbare Leistungseinbußen hinnehmen muß, und anderseits auch bei voller Leistungsfähigkeit betreibbar ist. Wie bereits erwähnt ist hierbei an die tragbaren PCs zu denken, die vom Versorgungsnetz abgekoppelt mit einer Batteriespannung von 1,1 bis 1,2 V betrieben werden können, wobei dann die Batterie eine lange Betriebsdauer erlaubt, oder mit einer Batteriespannung von ca. 3,3 bis 3,6 V, was eine relativ kurze Betriebsdauer nur ermöglicht (Parallel- bzw. Reihenschaltung einzelner Batteriezellen). Auch die Verwendung des integrierten Halbleiterschaltkreises in PCs, die nicht netzunabhängig betrieben werden, erlaubt eine enorme Energieeinsparung, die unter Umständen aufwendige Kühleinrichtungen (Gebläse etc) überflüssig oder deren Zuschaltung von der Belastung des integrierten Halbleiterschaltkreises abhängig macht. In dem PC können alle verwendeten Halbleiterchips mit den erfindungsgemäßen integrierten Halbleiterschaltkreisen ausgestattet sein, um einen optimalen Betrieb und eine maximale Energieeinsparung zu ermöglichen. Denkbar sind für bestimmte Anwendungsfälle auch Chips, auf denen nur ein Teil der Schaltkreise gemäß der Erfindung ausgebildet sind. Die Umschaltung auf die niedrigere Spannung kann beispielsweise immer dann erfolgen, wenn die Tastatur eine bestimmte Zeit nicht betätigt wurde. Eine andere Möglichkeit ist die Verwendung von Software, die die Auslastung des integrierten Halbleiterschaltkreises insbesondere hinsichtlich seiner erforderlichen Taktfrequenz ermittelt, und dann, in Abhängigkeit davon, die entsprechende Versorgungsspannung und damit auch zugeordnete Schwellwertspannung einstellt.

Nachfolgend wird die Erfindung anhand eines Ausführungsbeispiel in Verbindung mit den Zeichnungen näher erläutert. Die Zeichnungen stellen dar:
- Fig. 1: die schematische Struktur eines CMOS-Transistorpaares;
- Fig. 2: ein Blockschaltbild für die Bereitstellung der Vorspannungen; und
- Fig. 3: die Vorspannungsgeneratorsschaltungen zur Erzeugung der jeweiligen Vorspannung.

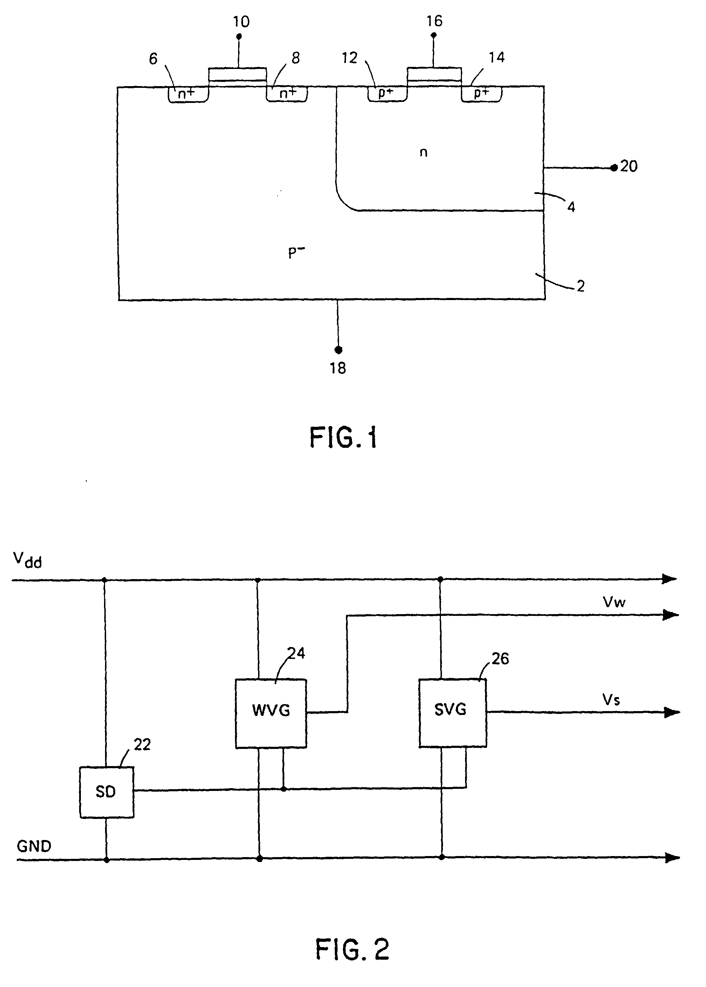

In Figur 1 ist die allgemein bekannte Struktur eine CMOS-Transistorpaares auf einem p-Substrat 2 und einer n-Wanne 4, sowie den n-dotierten Drain- und Source-Gebieten 6, 8 im p-Substrat 2 und den p-dotierten Drain- und Source-Gebieten 12, 14 in der n-Wanne 4 dargestellt. Dazwischen befinden sich die entsprechenden Gate-Anschlüsse 10 bzw. 16. Substrat und Wanne weisen ebenfalls elektrische Anschlüsse 18 bzw. 20 auf.

Diese Beschreibung gilt für den n-Wannen-Prozeß. Entsprechendes gilt für den p-Wannen-Prozeß, bei dem der n-Transistor in einer p-Wanne und der p-Transistor im Substrat angeordnet sind, und für den twin-WannenProzeß, bei dem der p-Transistor in einer n-Wanne und n-Transistor in einer p-Wanne angeordnet sind.

Berechnungen haben ergeben, daß beispielsweise bei einer Versorgungsspannung von 3,6 V, einer Taktfrequenz von 66 MHz und einem relativen Energieverbrauch von 1, nach der Umschaltung auf eine Versorgungsspannung von 1,2 V und einer Taktfrequenz von kleiner 5 MHz sich ein relativer Energieverbrauch von kleiner 0,01 und eine Verlängerung der Betriebszeit bei einem batteriebetriebenen PC um das ca. 100fache erreichen läßt.

Mit den nachfolgenden Betriebswerten könnte sich folgender Leistungsverbrauch ergeben:
Vdd= 3,6 V, Frequenz(=F)= 66 MHz, rel. Leistung= 100%;
Vdd= 1,2 V, F = 22 MHz, rel. Leistung= 3,7%;
Vdd= 1,2 V, F = 5 MHz, rel. Leistung= 0,8%;

Dabei trägt die Maßnahme gemäß der Erfindung mit der Spannungsreduzierung von 3,6 V auf 1,2 V mit einem Faktor 9 nur zur Reduzierung der Verlustleistung bei.

Nachfolgend ein Beispiel für die Spannungswerte:
- Vdd =: positive Versorgungsspannung,
- Vss =: negative Versorgungsspannung,
- VthN =: Schwellwertspannung am n-Transistor,
- VthP =: Schwellwertspannung am p-Transistor,
- Vs =: Substratvorspannung,
- Vw =: Wannenvorspannung

Vdd = 3,6 V : VthN = 0,55 V, VthP = -0,55 V
Vdd = 1,2 V : VthN = 0,3 V, VthP = -0,3 V
Vss = GND

dazu gehören die variablen Wannen- bzw. Substratvorspannungen
Vdd = 3,6 V : Vs = Vss - 0,7 V, Vw = Vdd + 0,7 V
Vdd = 1,2 V : Vs = Vss Vw = Vdd.

Die Spannungen auf dem Halbleiter betragen dann

| | |
|---|---|
| Vdd = 3,6 V | Vdd = 1,2 V |
| Vss = 0 V | Vss = 0 V |

| | | |
|---|---|---|
| n-Wanne | 4,3 V | 1,2 V |
| Source (P) | 3,6 V | 1,2 V |
| Source (N) | 0,0 V | 0,0 V |
| p-Substrat | -0,7 V | 0,0 V. |

Figur 2 zeigt schematisch beispielhaft in einem Blockschaltbild den Spannungsdetektor 22, der auf dem jeweiligen Halbleiterchip oder auch entfernt davon vorgesehen werden kann, und abhängig von der jeweils anliegenden Versorgungsspannung ein Eingangssignal für die Vorspannungsgeneratoren 24 und 26 abgibt. Der Wannenvorspannungsgenerator 24 gibt dann eine entsprechende Ausgangsspannung Vw für die Wanne und der Substratvorspannungsgenerator 26 eine entsprechende Spannung Vs für das Substrat ab. Die Bereitstellung dieser Spannungen kann bei einem PC selbstverständlich einmalig für alle betroffenen Halbleiterchips mit entsprechend vorgesehenen Spannungsverteilungssystemen und dotierten CMOS-Transistorpaaren erfolgen.

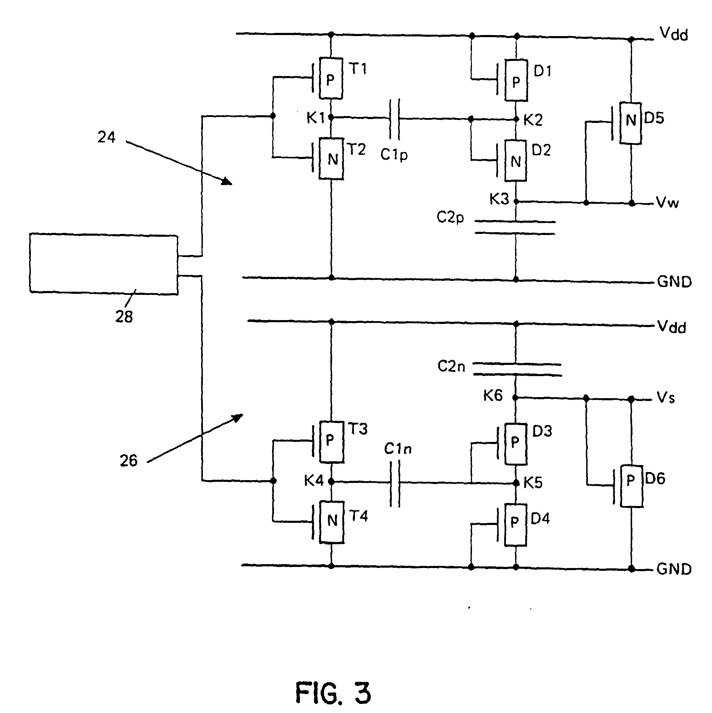

In Figur 3 ist ein Beispiel für eine Schaltung für die Vorspannungsgeneratoren 24 und 26 in CMOS-Technik dargestellt. In der Wannenvorspannungsgeneratorschaltung liegen die komplementären Transistoren T1 und T2 in Reihe zwischen der Versorgungsspannung Vdd und Gnd, wobei der p-Transistor T1 mit Vdd und der n-Transistor T2 mit Gnd verbunden ist. Die beiden Steuerelektroden der Transistoren sind an einen Ringoszillator 28 angeschlossen, der Impulse in einem weiten Frequenzbereich entsprechend der Dimensionierung der Schaltkreise liefert (bevorzugter Bereich 1 MHz ... 100 MHz). Zwischen Vdd und Gnd ist außerdem in Reihe geschaltet ein als Diode geschalteter n-Transistor D1, dessen Steuerelektrode ebenfalls an Vdd angeschlossen ist, ein weiterer als Diode geschalteter n-Transistor D2, dessen Steuerelektrode mit dem gemeinsamen Knoten K2 zwischen den Transistoren verbunden ist, und ein Kondensator C2p. Der gemeinsame Punkt K1 zwischen den Transistoren T1 und T2 ist über einen Kondensator Clp mit dem Punkt K2 verbunden. Zwischen dem Knoten K3 zwischen dem Transistor D2 und dem Kondensator C2p und Vdd ist noch ein zusätzlicher als Diode beschalteter n-Transistor D5 geschaltet, dessen Steuerelektrode auf dem Potential des Knotens K3 liegt. Das Potential des Knotens K3 liefert die Wannenvorspannung Vw.

Die Schaltung für den Substratvorspannungsgenerator 26 ist in ähnlicher Weise aufgebaut. Den Transistoren T1 und T2 entsprechende Transistoren T3 und T4, deren Steuerelektroden mit dem Ringoszillator 28 verbunden sind, sind in Reihe zwischen Vdd und Gnd geschaltet. Zwischen Vdd und Gnd ist in Reihe ein Kondensator C2n und zwei als Dioden beschaltetet p-Transistoren D3 und D4 geschaltet, deren Steuerelektroden mit dem Knoten K5 zwischen den beiden Transistoren bzw. Gnd verbunden sind. Der Knoten K4 zwischen den Transistoren T3 und T4 ist über den Kondensator Cln mit dem Knoten K5 verbunden. Entsprechend ist der Knoten K6 zwischen dem Kondensator C2n und dem Transistor D3 über einen als Diode geschalteten p-Transistor D6 mit Gnd verbunden, dessen Steuerelektrode ebenfalls auf dem Potential des Knotens K6 liegt. Das Potential des Knotens K6 stellt die Substratvorspannung Vs dar.

Die Schaltung für den Wannenvorspannungsgenerator 24 funktioniert in der Weise, daß über den Ringoszillator 28 eine Folge von Rechteckimpulsen an die Steuerelektroden der Transistoren T1 und T2 gelegt werden. Mit der positiven Flanke schaltet der Transistor T2 durch und die Versorgungsspannung Vdd wird, vermindert um die Spannungsabfälle an dem Transistor T2 und D1, an den Kondensator Clp angelegt. Mit der negativen Flanke schaltet der Transistor T1 durch und die Ladung des Kondensators Clp fließt zum Teil auf den Kondensator C2p. Die Spannung am Knoten K2 (VK2) und damit die Spannung über C2p kann dabei Werte erreichen, die über Vdd liegen (theoretisch: VK2 ≅ 2 Vdd). Dabei muß jedoch zuerst der Kondensator Clp umgeladen werden, so daß sich die Spannung am Kondensator C2p um die Spannungsabfälle an den Transistoren T1 und D2 vermindert. Mit jedem Impuls wird der Kondensator C2p höher aufgeladen, wobei jedoch durch den als Diode geschalteten Transistor D5 die Spannung am Kondensator C2p und damit die Ausgangsspannung für die Wanne auf eine Spannung begrenzt wird, die um die Diodendurchlaßspannung erhöht ist.

Entsprechend funktioniert die Schaltung für die Substratvorspannung. Mit der positiven Flanke schaltet der Transistor T4 durch und der Kondensator C2n wird auf eine Spannung entsprechend den Kapazitäten des aus den Kondensatoren Cln und C2n gebildeten Spannungsteilers vermindert um die Spannungsabfälle an den Transistoren T4 und D3 aufgeladen. Nach dem Durchschalten des Transistors T3 durch die negative Flanke des Rechteckimpulses wird der Kondensator auf maximal die um die Spannungsabfälle an den Transistoren T3 und D4 reduzierte Versorgungsspannung Vdd umgeladen. Mit dem nächsten positiven Impuls wird wieder der Transistor T4 durchgeschaltet und damit der Knoten K4 und gleichzeitig die Elektrode des Kondensators C1n auf Gnd-Potential gelegt. Mit der Vorspannung des Kondensators C1n aus dem vorangegangen Impuls wird das Potential des Knotens K5 auf negatives Potential gebracht bis der Transistor D3 leitet und sich die Ladung des Kondensators Cln auf die beiden Kondensatoren Cln und C2n entsprechend ihrer Kapazität aufteilt. Dadurch erhält der Knoten K6 und damit die Substratvorspannung Vs ein negatives Potential. Nach einer gewissen Zeit pegelt sich die Spannung Vs auf einen Endwert ein, der durch den Transistor D6 begrenzt wird.

Die Auswahl der Bauelemente, insbesondere der Kondensatoren, richtet sich nach den Bedürfnissen der Ausgangsspannungen und der gewünschten Zeiten bis sich der Endwert eingestellt hat. Diese Auswahl kann durch den Fachmann aufgrund seines Fachwissens leicht vorgenommen werden, da sie vom Fachmann ausgewählt werden können bzw. durch die Chipgröße und -auslegung gegeben sind. Beispielhafte Werte für die Kondensatoren sind:
- C1p =: 5pF,
- C2p =: 5nF,
- C1n =: 5pF, und
- C2n =: 5nF.

## Patentansprüche

1. Integrierter Halbleiterschaltkreis in CMOS-Technik der mit verschiedenen Versorgungsspannungen (Vdd) stabil betreibbar ist, indem die Schwellwertspannung der beteiligten CMOS-Transistorpaare entsprechend der jeweils anliegenden Versorgungsspannung über die Wannen- und die Substratvorspannung (Vw, Vs) einstellbar ist, wobei das Substrat (2) des CMOS-Transistorpaares mit einer Substratvorspannungsgeneratorschaltung (SVG) und die Wanne mit einer Wannenvorspannungsgeneratorschaltung (WVG) verbunden ist, die in Abhängigkeit von einem Eingangssignal, das die Höhe der Versorgungsspannung repräsentiert, die jeweilige, der Höhe der Versorgungsspannung entsprechende Vorspannung einstellt, um die Schwellwertspannung derart an die jeweilige Versorgungsspannung anzupassen, daß immer ein stabiler Betrieb des Transistorpaares gewährleistet ist, wobei die Versorgungsspannung in Abhängigkeit von der Taktfrequenz einstellbar ist und bei höherer Taktfrequenz eine höhere Versorgungsspannung anliegt und bei reduzierter Taktfrequenz eine geringere Versorgungsspannung anliegt.

2. Integrierter Halbleiterschaltkreis nach Anspruch 1 bei dem ein Spannungsdetektor (SD) das Eingangssignal für die Vorspannungsgeneratorschaltungen erzeugt.

3. Integrierter Halbleiterschaltkreis nach Anspruch 1 oder 2 bei dem ein stabiler Betrieb bei einer Versorgungsspannung (Vdd) von ungefähr 3,6 V und ungefähr 1,2 V erfolgt.

4. Integrierter Halbleiterschaltkreis nach Anspruch 3 bei dem das Substrat (2) unterhalb der Oberfläche mit einer ungefähren Konzentration von 7,5x10¹⁵ cm⁻³ bis 4x10¹⁶ cm⁻³, vorzugsweise 2,5x10¹⁶ cm⁻³ dotiert ist.

5. Integrierter Halbleitschaltkreis nach einem der vorangegangenen Ansprüche 1 bis 4 der mit einer Versorgungsspannung (Vd) von ungefähr 3,6 V bei maximaler Taktfrequenz und mit einer Versorgungsspannung von ungefähr 1,2 V bei reduzierter Taktfrequenz betrieben wird.

6. Integrierter Halbschalterkreis nach einem der vorangegangen Ansprüche 1 bis 5 bei dem die Versorgungsspannung (Vd) und damit auch das Eingangssignal für die Vorspannungsgeneratorschaltungen in Abhängigkeit von der Auslastung des integrierten Halbleiterschaltkreises steuerbar ist.

7. Integrierter Halbleiterschaltkreis nach einem der vorangegangen Ansprüche 1 bis 5 bei dem die Versorgungsspannung (Vd) und das Eingangssignal von der Dauer der Nichtbenutzung der zugehörigen Eingabeeinheit abhängig ist.

8. Datenverarbeitungssystem, mit wenigstens einem integrierten Halbleiterschaltkreis in CMOS-Technik nach einem der vorangegangenen Ansprüche 1-7.

## Claims

1. Integrated semiconductor circuit employing CMOS technology which can operate stably at different supply voltages (Vdd), in that the threshold voltage of the CMOS transistor pairs involved can be set corresponding to the existing supply voltage via the well and substrate bias voltages (Vw, Vs), whereby the substrate of the CMOS transistor pair is connected to a substrate bias voltage generator (SVG) circuit and the well is connected to a well bias voltage generator (WVG) circuit which, depending on an input signal representing the supply voltage level, sets the respective bias voltages corresponding to the level of the supply voltage, in order to adapt the threshold voltage to the existing supply voltage so that stable operation of the transistor pair is always ensured, where the supply voltage is adjustable as a function of the clock rate and provides a higher supply voltage at higher clock rates and a lower supply voltage at reduced clock rates.

2. Integrated semiconductor circuit in accordance with Claim 1, in which a voltage detector (SD) generates the input signal for the bias voltage generator circuits.

3. Integrated semiconductor circuit in accordance with any one of the preceding claims, in which stable operation occurs at supply voltages (Vdd) of approximately 3.6 V and approximately 1.2 V.

4. Integrated semiconductor circuit in accordance with Claim 3, in which the substrate (2) is doped below the surface with a concentration of approximately 7.5x10¹⁵ cm⁻³ to approximately 4x10¹⁶ cm⁻³, preferably 2.5x10¹⁶ cm⁻³.

5. Integrated semiconductor circuit in accordance with one of the foregoing Claims 1 - 4 which is operated with a supply voltage (Vd) of approximately 3.6 V at maximum clock rate and with a supply voltage (Vd) of approximately 1.2 V at reduced clock rate.

6. Integrated semiconductor circuit in accordance with one of the foregoing Claims 1 - 5 in which the supply voltage (Vd) and hence also the input signal for the bias voltage generator is controllable as a function of the load on the integrated semiconductor circuit.

7. Integrated semiconductor circuit in accordance with one of the foregoing Claims 1 - 5 in which the supply voltage (Vd) and hence also the input signal is dependent on the duration of non-use of the corresponding input unit.

8. Data processing system having at least one integrated semiconductor circuit employing CMOS technology, in accordance with one of the foregoing Claims 1 - 7.

## Revendications

1. Circuit intégré à semi-conducteurs répondant à la technique CMOS, pouvant fonctionner de façon stable avec différentes tensions d'alimentation (Vdd), dans lequel la tension de valeur de seuil des paires de transistors CMOS concernés est réglable, de manière correspondante chaque fois à la tension d'alimentation appliquée, par l'intermédiaire des pré-tensions de boîtier et de substrats (Vw, Vs), le substrat de la paire de transistors CMOS étant relié à un circuit générateur de pré-tension de substrat (SVG) et le boîtier est relié à un circuit générateur de pré-tension de boîtier (WVG), qui, en fonction d'un signal d'entrée qui représente la hauteur de la tension d'alimentation, règle la pré-tension respective, correspondant à la valeur de la tension d'alimentation, pour adapter la tension de valeur de seuil à la tension d'alimentation respective, de manière que soit toujours assuré un fonctionnement stable de la paire de transistors, la tension d'alimentation étant réglable en fonction de la fréquence de cadencement et, en cas de haute fréquence de cadencement, une tension d'alimentation plus élevée étant appliquée et, en cas d'une fréquence de cadencement réduite, une tension d'alimentation plus basse étant appliquée.

2. Circuit intégré à semi-conducteurs selon la revendication 1, dans lequel le détecteur de tension (SD) génère le signal d'entrée pour les circuits générateurs de pré-tension.

3. Circuit intégré à semi-conducteurs selon la revendication 1 ou 2, dans lequel un fonctionnement stable s'effectue pour une tension d'alimentation (Vdd) d'environ 3,6 V et d'environ 1,2 V.

4. Circuit intégré à semi-conducteurs selon la revendication 3, dans lequel le substrat 2 est doté au-dessous de la surface d'une concentration approximative de 7,5x10¹⁵ cm⁻³ à 4x10¹⁶ cm⁻³, de préférence 2,5x10¹⁶ cm⁻³.

5. Circuit intégré à semi-conducteurs selon l'une des revendications 1 à 4 précédentes, fonctionnant à une tension d'alimentation (Vd) d'environ 3,6 V, pour une fréquence de cadencement maximale, et à une tension d'alimentation d'environ 1,2 V, pour une fréquence de cadencement réduite.

6. Circuit intégré à semi-conducteurs selon l'une des revendications 1 à 5 précédentes, dans lequel la tension d'alimentation (Vd) et ainsi également le signal d'entrée des circuits générateurs de pré-tensions et susceptible d'être commandé en fonction de l'utilisation du circuit intégré à semi-conducteur.

7. Circuit intégré à semi-conducteurs selon l'une des revendications 1 à 5 précédentes, dans lequel la tension d'alimentation (Vd) et le signal d'entrée dépendent de la durée de la non-utilisation de l'unité d'introduction afférente.

8. Système de traitement de données, équipé d'au moins un circuit intégré à semi-conducteurs réalisé selon la technique CMOS, selon l'une des revendications 1 à 7 précédentes.
